# EUROPEAN PATENT APPLICATION

(11) **EP 3 101 663 A1**
(43) Date of publication of application: **07.12.2016**
(21) Application number: 15742801.2
(22) Date of filing: 19.01.2015
(51) Int. Cl.: H01B 5/14, G06F 3/041, H01G 9/20, H01L 51/44

(54) **TRANSPARENT CONDUCTIVE FILM, PHOTOELECTRODE FOR DYE-SENSITIZED SOLAR CELLS, TOUCH PANEL AND DYE-SENSITIZED SOLAR CELL**

(30) Priority: 31.01.2014 JP 2014017681
(71) Applicant: Zeon Corporation, Tokyo 100-8246 (JP)
(72) Inventor: YOSHIWARA, Akihiko, Tokyo 100-8246 (JP); KOJIMA, Kiyoshige, Tokyo 100-8246 (JP); KOJIMA, Akihiro, Yokohama-shi Kanagawa 225-8502 (JP); IKEGAMI, Masashi, Yokohama-shi Kanagawa 225-8502 (JP)
(74) Representative: Vossius & Partner Patentanwälte Rechtsanwälte mbB
(86) International application number: PCT/JP2015/000198
(87) International publication number: WO 2015/115048

(57) **Abstract**

An oxide layer (2) of tin or niobium is formed on one surface of a carbon nanotube-containing layer (1) containing carbon nanotubes having an average diameter (Av) and a diameter standard deviation (σ) that satisfy a relationship 0.60 > 3σ/Av > 0.20.

## Description

### TECHNICAL FIELD

The present disclosure relates to a transparent conductive film that has excellent transparency and conductivity, and that enables improvement of cell characteristics such as photoelectric conversion efficiency when used for a photoelectrode of a dye-sensitized solar cell.

The present disclosure also relates to a photoelectrode for a dye-sensitized solar cell and a touch panel that each include the aforementioned transparent conductive film, and to a dye-sensitized solar cell that includes the aforementioned photoelectrode.

### BACKGROUND

Transparent conductive films are for example used in photoelectrodes of dye-sensitized solar cells and in touch panels. Particularly in the case of conductive films used in photoelectrodes of dye-sensitized solar cells, such conductive films are expected to demonstrate a balance of both high transparency and high conductivity.

ITO (Indium Tin Oxide) thin films containing indium oxide and tin oxide as main components are currently being put into practical use as such transparent conductive films.

However, increasing demand for ITO thin films has in recent years led to problems such as worsening of resource depletion and a rise in the cost of indium used as a raw material of such ITO thin films.

Therefore, there is much interest in transparent conductive films that do not contain indium (i.e., ITO substitute materials). Transparent conductive films containing carbon nanotubes (hereinafter also referred to as "CNTs") are attracting attention as examples of such ITO substitute materials.

CNT-containing transparent conductive films are thought to be promising ITO substitute materials due to having excellent durability and having lower production costs than ITO thin films.

However, when compared to ITO thin films, CNT-containing transparent conductive films do not necessarily have adequate transparency and conductivity, and there is demand for further improvement in terms of these properties.

Furthermore, in a situation in which a CNT-containing transparent conductive film is used as a conductive film of a photoelectrode at a negative electrode-side of a dye-sensitized solar cell, the CNTs may act as a catalyst for reduction of an oxidant present in an electrolysis solution. If this action by the CNTs is maintained, reverse current may be generated due to reduction of an electrolyte and, as a result, cell characteristics such as photoelectric conversion efficiency may be reduced.

In one example of a technique relating to a CNT-containing transparent conductive film such as described above, PTL 1 discloses a conductive composite that is formed by producing a film using a CNT dispersion liquid that contains a dispersant having a sulfonate group in molecules thereof and subsequently forming an overcoating film using a specific metal alkoxide.

Furthermore, NPL 1 discloses a technique in which, with respect to a CNT transparent conductive film, an amorphous titanium oxide layer is formed on the surface of the CNTs by a sol-gel method using a titanium alkoxide solution.

### CITATION LIST

### Patent Literature

PTL 1: JP 2012-160290 A

### Non-patent Literature

NPL 1: "Dye-sensitized solar cell with a titanium-oxide-modified carbon nanotube transparent electrode", APPLIED PHYSICS LETTERS 99, 021107 (2011)

### SUMMARY

### (Technical Problem)

However, the technique disclosed by PTL 1 is largely restrictive in terms of production because it is necessary to use a specific dispersant, and transparency and conductivity of the CNT film are not thought to be adequate.

Furthermore, in the case of the technique disclosed by NPL 1, the amorphous titanium oxide layer formed on the surface of the CNTs is not thought to be sufficiently conductive and the effect of this technique on improving cell characteristics such as photoelectric conversion efficiency is inadequate.

The present disclosure, which results from development carried out in light of the circumstances described above, has an objective of providing a transparent conductive film that has excellent transparency and conductivity, and that enables improvement in cell characteristics such as photoelectric conversion efficiency when used for a photoelectrode of a dye-sensitized solar cell.

Another objective of the present disclosure is to provide a photoelectrode for a dye-sensitized solar cell and a touch panel that are each obtainable using the aforementioned transparent conductive film, and a dye-sensitized solar cell that is obtainable used the aforementioned photoelectrode.

### (Solution to Problem)

Initially, the present inventors conducted diligent investigation of the characteristics of CNTs contained in a transparent conductive film with an objective of increasing transparency and conductivity of the CNT-containing transparent conductive film.

As a result of this investigation, the inventors discovered that transparency and conductivity of the transparent conductive film could be significantly improved by using CNTs having an average diameter (Av) and a diameter standard deviation (σ) satisfying a relationship 0.60 > 3σ/Av > 0.20 as the CNTs contained in the transparent conductive film.

However, when a dye-sensitized solar cell was prepared using the transparent conductive film containing these CNTs for a photoelectrode, photoelectric conversion efficiency measured with respect to the prepared dye-sensitized solar cell did not improve as much as was expected.

The following became clear as a result of the inventors conducting detailed investigation into the cause of this result.

Specifically, the inventors discovered that although transparency and conductivity can be increased through the aforementioned CNTs, this increase is accompanied by an increase in catalytic action of the CNTs. Consequently, when these CNTs are used in a photoelectrode of a dye-sensitized solar cell, the CNTs act as a catalyst for reduction of an oxidant in an electrolysis solution, and as a result of the catalytic action of the CNTs, reverse current is generated due to electrolyte reduction. Thus, the inventors were able to determine the reason that photoelectric conversion efficiency of the dye-sensitized solar cell did not improve as much as was expected.

The inventors conducted further investigation with an objective of preventing generation of reverse current such as described above by forming a protective layer.

As a result of this investigation, the inventors discovered that a layer of an oxide of tin or niobium is most appropriate as a protective layer provided on a transparent conductive film containing the above-described CNTs. The inventors also discovered that when such a protective layer is provided, catalytic action of the CNTs can be deactivated and generation of reverse current can be prevented without reducing transparency or conductivity, and that consequently, further improvement of photoelectric conversion efficiency can be achieved.

The present disclosure is based on the findings described above.

Specifically, primary features of the present disclosure are as follows.
1. A transparent conductive film comprising a carbon nanotube-containing layer (1) containing carbon nanotubes having an average diameter (Av) and a diameter standard deviation (σ) that satisfy a relationship 0.60 > 3σ/Av > 0.20, and an oxide layer (2) of tin or niobium on one surface of the carbon nanotube-containing layer (1).
2. The transparent conductive film described in 1, wherein the carbon nanotube-containing layer (1) further contains a metal nanostructure.
3. The transparent conductive film described in 1, further comprising a metal nanostructure-containing layer (3) on another surface of the carbon nanotube-containing layer (1).
4. A photoelectrode for a dye-sensitized solar cell, the photoelectrode comprising the transparent conductive film described in any one of 1-3.
5. A touch panel comprising the transparent conductive film described in any one of 1-3.
6. A dye-sensitized solar cell comprising the photoelectrode described in 4.

### (Advantageous Effect)

According to the present disclosure, a transparent conductive film can be obtained that has excellent transparency and conductivity, and that effectively prevents generation of reverse current when used for a photoelectrode of a dye-sensitized solar cell.

Moreover, a dye-sensitized solar cell having improved cell characteristics such as photoelectric conversion efficiency can be produced through application therein of the presently disclosed transparent conductive film.

### BRIEF DESCRIPTION OF THE DRAWINGS

In the accompanying drawings:
FIG. 1 illustrates an overview of configuration of one example of a presently disclosed transparent conductive film;
FIG. 2 illustrates an overview of configuration of another example of a presently disclosed transparent conductive film; and
FIG. 3 illustrates an overview of configuration of a dye-sensitized solar cell.

### DETAILED DESCRIPTION

The following provides a detailed description of the present disclosure. First, a presently disclosed transparent conductive film is described.

### [Transparent conductive film]

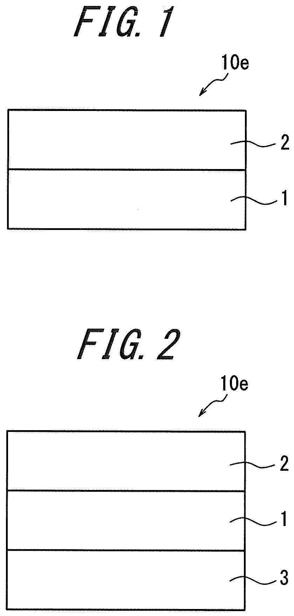

As illustrated in FIG. 1, the presently disclosed transparent conductive film includes a CNT-containing layer (1) (hereinafter also referred to simply as CNT layer (1)) containing CNTs having an average diameter (Av) and a diameter standard deviation (σ) that satisfy a relationship 0.60 > 3σ/Av > 0.20, and an oxide layer (2) of tin or niobium on one surface of the CNT layer (1).

Note that in FIG. 1, reference sign 1 indicates the CNT layer (1) and reference sign 2 indicates the oxide layer (2) of tin or niobium.

Herein, it is important that CNTs having the characteristics described below are used as the CNTs contained in the CNT layer (1).

### 0.60 > 3σ/Av > 0.20

CNTs composing the CNT layer (1) are required to have an average diameter (Av) and a diameter standard deviation (σ) that satisfy the relationship 0.60 > 3σ/Av > 0.20. The reason for this is that excellent transparency and conductivity can be obtained in the CNT layer (1) as a result of the aforementioned relationship being satisfied. Preferably a relationship 0.60 > 3σ/Av > 0.25 is satisfied, and more preferably a relationship 0.60 > 3σ/Av > 0.50 is satisfied.

Note that "3σ" refers to a diameter distribution obtained by multiplying the (sample) standard deviation (σ) of CNT diameters by 3. The "average diameter (Av)" and the "diameter standard deviation (σ)" can each be obtained by measuring the diameters of 100 randomly selected CNTs using a transmission electron microscope (average length described below can be obtained as an average value of lengths measured by the same method). Also, the "diameter" of a CNT refers to the outer diameter of the CNT. The CNTs used herein normally take a normal distribution when a plot is made of diameter measured as described above on a horizontal axis and probability density on a vertical axis, and a Gaussian approximation is made.

In addition to the characteristics described above, CNTs used herein preferably have the following characteristics.

### Average diameter (Av): 0.5 nm to 15 nm

The average diameter (Av) of the CNTs is preferably in a range of from 0.5 nm to 15 nm. The reason for this is that transparency and conductivity of the CNT layer (1) can be further improved as a result of the average diameter (Av) of the CNTs being in the range described above. The average diameter (Av) of the CNTs is more preferably in a range of from 1 nm to 10 nm.

### Average length: 0.1 µm to 1 cm

The average length of the CNTs is preferably in a range of from 0.1 µm to 1 cm. The reason for this is that transparency and conductivity of the CNT layer (1) can be further improved as a result of the average length of the CNTs being in the range described above. The average length of the CNTs is more preferably in a range of from 0.1 µm to 1 mm.
Specific surface area: 100 m²/g to 2,500 m²/g

The specific surface area of the CNTs is preferably in a range of from 100 m²/g to 2,500 m²/g. The reason for this is that transparency and conductivity of the CNT layer (1) can be further improved as a result of the specific surface area of the CNTs being in the range described above. The specific surface area of the CNTs is more preferably in a range of from 400 m²/g to 1,600 m²/g.

Note that the specific surface area of the CNTs can be obtained by nitrogen gas adsorption.
Mass density: 0.002 g/cm³ to 0.2 g/cm³

The mass density of the CNTs is preferably in a range of from 0.002 g/cm³ to 0.2 g/cm³. The reason for this is that transparency and conductivity of the CNT layer (1) can be further improved as a result of the mass density of the CNTs being in the range described above. The mass density of the CNTs is a value measured with respect to an aligned CNT aggregate obtained directly from a CNT production method described further below.

The CNTs may be single-walled CNTs or multi-walled CNTs. However, from a viewpoint of improving conductivity, CNTs having from one to five walls are preferable, and single-walled CNTs are more preferable.

The CNTs may have a functional group such as a carboxyl group or the like introduced onto the surface thereof. The functional group may be introduced by a commonly known oxidation treatment method such as through use of hydrogen peroxide, nitric acid, or the like.

The CNTs preferably have micropores. The micropores in the CNTs are preferably pores that are smaller than 2 nm in diameter. In terms of the amount of micropores in the CNTs, micropore volume obtained by a method described below is preferably at least 0.4 mL/g, more preferably at least 0.43 mL/g, and particularly preferably at least 0.45 mL/g, and normally has an upper limit of approximately 0.65 mL/g. It is preferable that the CNTs have micropores such as described above from a viewpoint of improving conductivity. The micropore volume can for example be adjusted through appropriate alteration of a preparation method and preparation conditions of the CNTs.

Herein, "micropore volume (Vp)" can be calculated from equation (I)-Vp = (V/22,414) x (M/ρ)-by measuring a nitrogen adsorption isotherm of the CNTs at liquid nitrogen temperature (77 K) and by setting an amount of adsorbed nitrogen at a relative pressure P/P0 = 0.19 as V. It should be noted that P is a measured pressure at adsorption equilibrium, P0 is a saturated vapor pressure of liquid nitrogen at time of measurement, and, in equation (I), M is a molecular weight of 28.010 of the adsorbate (nitrogen) and ρ is a density of 0.808 g/cm³ of the adsorbate (nitrogen) at 77 K. The micropore volume can for example be easily obtained using a BELSORP^{®}-mini (BELSORP is a registered trademark in Japan, other countries, or both) produced by Bel Japan Inc.

The CNTS having the characteristics described above can for example be efficiently produced through a method (super growth method; refer to WO 2006/011655 A1) in which, during synthesis of carbon nanotubes through chemical vapor deposition (CVD) by supplying a feedstock compound and a carrier gas onto a substrate (hereinafter also referred to as a "substrate for CNT production") having a catalyst layer for CNT production on the surface thereof, catalytic activity of the catalyst layer for CNT production is dramatically improved by providing a trace amount of an oxidizing agent in the system, wherein the catalyst layer is formed on the surface of the substrate through a wet process and a feedstock gas having acetylene as a main component (for example, a gas including at least 50 vol% of acetylene) is used.

The thickness of the CNT layer (1) described above is preferably in a range of from 1 nm to 0.1 mm from a viewpoint of transparency and conductivity.

A CNT dispersion liquid used to form the CNT layer (1) can be prepared in accordance with a standard method without the need to use a special method. For example, the CNT dispersion liquid can be obtained by mixing the CNTs and other components such as a binder, a conductive additive, a dispersant, and a surfactant as required in a solvent such as water or an alcohol, and dispersing the CNTs. Herein, the CNT content in the CNT dispersion liquid is preferably in a range of from 0.001 mass% to 10 mass%, and more preferably in a range of from 0.001 mass% to 5 mass%.

Through the above, characteristics and so forth of the CNTs composing the CNT layer (1) have been explained. Herein, it is important that the oxide layer (2) of tin or niobium is formed on one surface of the CNT layer (1).

In other words, in a situation in which a transparent conductive film composed of the CNT layer (1) is adopted in a photoelectrode of a dye-sensitized solar cell, due to the fact that not only transparency and conductivity of the CNT layer (1), but also catalytic action is increased, reverse current is generated due to the CNTs acting as a catalyst for electrolyte reduction.

Therefore, it is necessary to prevent reverse current from being generated as described above without causing a reduction in transparency and conductivity. This is achieved herein by forming the oxide layer (2) of tin or niobium (hereinafter also referred to simply as oxide layer (2)) as a protective layer on one surface of the CNT layer (1) (i.e., a surface at an electrolyte-side of the CNT layer (1) when the CNT layer (1) is adopted in a photoelectrode of a dye-sensitized solar cell).

Consequently, the presently disclosed transparent conductive film can prevent generation of reverse current without causing a reduction in transparency and conductivity, and photoelectric conversion efficiency of a dye-sensitized solar cell in which the transparent conductive film is adopted can be significantly improved.

From a viewpoint of deactivating catalytic action of the CNTs and preventing generation of reverse current, the oxide layer (2) preferably has a thickness of at least 0.1 nm, and more preferably at least 1 nm.

However, it is difficult to obtain a balance of both transparency and conductivity if the thickness of the oxide layer (2) is greater than 300 nm.

The oxide layer (2) of tin or niobium can for example be formed by preparing a treatment solution by dissolving a typical metal alkoxide of tin or niobium in an organic solvent, applying the treatment solution by a standard method such as spin coating, spraying, or bar coating, and performing heating appropriately in accordance with substrate heat resistance in a temperature range of from 50°C to 600°C, using a hot plate, an oven, or the like.

Herein, the metal alkoxide of tin or niobium can for example be tin tetramethoxide, tin tetraethoxide, tin tetraisopropoxide, tin bis(2-ethylhexanoate), diacetoxytin, niobium pentamethoxide, niobium pentaethoxide, niobium pentaisopropoxide, niobium pentabutoxide, or niobium penta(2-ethylhexanoate). Besides the above examples, any other metal alkoxides of tin and niobium can be used without restriction. Any one of these metal alkoxides of tin and niobium may be used or any two or more of these metal alkoxides of tin and niobium may be used in combination.

Various organic solvents that can dissolve the metal alkoxide can be used as the solvent. Examples of such organic solvents include alcohols such as n-butanol and isopropyl alcohol (IPA), and ethanols such as 2-methoxyethanol. Besides these solvents, any other solvent in which a metal alkoxide of tin or niobium is soluble can be used without any specific restrictions.

Although no specific limitations are placed on the concentration of the metal alkoxide of tin or niobium, normally the concentration has a preferable range of from 0.0001 mol/L to 0.5 mol/L.

Through the above, configuration of the presently disclosed transparent conductive film has been described. Note that the CNT layer (1) may further contain a metal nanostructure in order to further improve conductivity.

Herein, the metal nanostructure is a fine structure made from a metal or a metal compound, and is used herein as a conductor.

No specific limitations are placed on the constituent metal or metal compound of the metal nanostructure other than being conductive. For example, the metal nanostructure may be made from a metal such as copper silver, platinum, or gold; a metal oxide such as indium oxide, zinc oxide, or tin oxide; or a composite metal oxide such as aluminum zinc oxide (AZO), indium tin oxide (ITO), or indium zinc oxide (IZO).

Among such examples, gold, silver, copper, and platinum are preferable in terms that excellent transparency and conductivity can be easily obtained.

Examples of metal nanostructures that can be used includes metal nanoparticles, metal nanowires, metal nanorods, and metal nanosheets.

Among these examples, metal nanoparticles are particle shaped structures having a nanometer scale average particle diameter. Although no specific limitations are placed on the average particle diameter of the metal nanoparticles (average particle diameter of primary particles), the average particle diameter is preferably from 10 nm to 300 nm. As a result of the average particle diameter being in the range described above, it is easier to obtain a conductive film having excellent transparency and conductivity.

The average particle diameter of the metal nanoparticles can be calculated by measuring the particle diameters of 100 randomly selected metal nanoparticles using a transmission electron microscope. The sizes of other metal nanostructures described below can be obtained by the same method.

The metal nanoparticles can for example be obtained by a commonly known method such as a polyol method in which an organic complex is reduced by a polyhydric alcohol to synthesize metal nanoparticles or a reverse micelle method in which a reverse micelle solution including a reductant and a reverse micelle solution including a metal salt are mixed to synthesize metal nanoparticles.

Metal nanowires are linear structures having a nanometer scale average diameter and an aspect ratio (length/diameter) of at least 10. Although no specific limitations are placed on the average diameter of the metal nanowires, the average diameter is preferably from 10 nm to 300 nm. Also, although no specific limitations are placed on the average length of the metal nanowires, the average length is preferably at least 3 µm.

As a result of the average diameter and the average length being in the ranges described above, it is easier to obtain a conductive film having excellent transparency and conductivity.

The metal nanowires can for example be obtained by a commonly known method such as a method in which an applied voltage or current is imparted on the surface of a precursor from a tip of a probe and a metal nanowire is pulled out by the probe tip to continuously form the metal nanowire (JP 2004-223693 A) or a method in which a nanofiber made from a metal complex peptide lipid is reduced (JP 2002-266007 A).

Metal nanorods are cylindrical structures having a nanometer scale average diameter and an aspect ratio (length/diameter) of at least 1 and less than 10. Although no specific limitations are placed on the average diameter of the nanorods, the average diameter is preferably from 10 nm to 300 nm. Also, although no specific limitations are placed on the average length of the nanorods, the average length is preferably from 10 nm to 3,000 nm.

As a result of the average diameter and the average length being in the ranges described above, it is easier to obtain a conductive film having excellent transparency and conductivity.

The metal nanorods can for example be obtained by a commonly known method such as electrolysis, chemical reduction, or photoreduction.

Metal nanosheets are sheet-shaped structures having a nanometer scale thickness. Although no specific limitations are placed on the thickness of the metal nanosheets, the thickness is preferably from 1 nm to 10 nm. Also, although no specific limitations are placed on the size of the metal nanosheets, a side length of the metal nanosheets is preferably from 0.1 µm to 10 µm. As a result of the thickness and the side length being in the ranges described above, it is easier to obtain a conductive film having excellent transparency and conductivity.

The metal nanosheets can be obtained by a commonly known method such as a method in which a layered compound is peeled, chemical vapor deposition, or a hydrothermal method.

Among the metal nanostructures described above, use of metal nanowires is preferable in terms of ease of achieving excellent transparency and conductivity.

Any one of the types of metal nanostructures listed above may be used or any two or more of the types of metal nanostructures listed above may be used in combination.

Although no specific limitations are placed on the metal nanostructure content in the CNT layer (1), the metal nanostructure content is preferably in a range of from 0.0001 mg/cm² to 0.05 mg/cm².

A dispersion liquid used to form the CNT layer (1) containing the metal nanostructure can be prepared in accordance with a standard method. For example, the dispersion liquid can be prepared by mixing the CNTs, the metal nanostructure, and other components such as a binder, a conductive additive, a dispersant, and a surfactant as required in a solvent such as water or an alcohol, and dispersing the CNTs and the metal nanostructure. Herein, the metal nanostructure content in the dispersion liquid is preferably in a range of from 0.001 mass% to 20 mass%.

Furthermore, the presently disclosed transparent conductive film may have a configuration such as illustrated in FIG. 2, in which a metal nanostructure-containing layer (3) is formed on the other surface of the CNT layer (1). Reference sign 3 in FIG. 2 indicates the metal nanostructure-containing layer (3).

In such a configuration, conductivity can be improved through the metal nanostructure. From a viewpoint of improving conductivity, the metal nanostructure-containing layer (3) preferably has a thickness in a range of from 30 nm to 1 mm.

Moreover, the metal nanostructure-containing layer (3) preferably has a metal nanostructure content in a range of from 0.0001 mg/cm² to 0.2 mg/cm².

The metal nanostructure-containing layer (3) may contain components other than the metal nanostructure to the extent that such components do not interfere with the effects disclosed herein.

The metal nanostructure-containing layer (3) can be obtained by preparing a dispersion liquid containing the metal nanostructure, applying the dispersion liquid onto a substrate such as a base plate, and drying the dispersion liquid thereon. Conditions for preparation, application, and drying of the metal nanostructure dispersion liquid may be in accordance with a standard method. The dispersion liquid preferably has a metal nanostructure content in a range of from 0.0001 mass% to 10 mass%.

### [Photoelectrode for dye-sensitized solar cell and dye-sensitized solar cell]

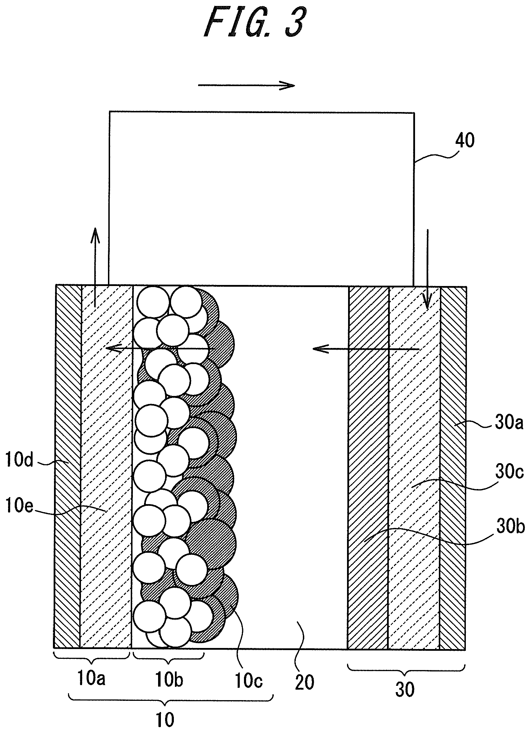

A dye-sensitized solar cell typically has a structure in which a photoelectrode 10, an electrolyte layer 20, and a counter electrode 30 are arranged in the stated order as illustrated in FIG. 3. The dye-sensitized solar cell has a mechanism in which electrons are removed from a sensitizing dye in the photoelectrode 10 upon excitation of the sensitizing dye through reception of light and the removed electrons move out of the photoelectrode 10 along an external circuit 40 to the counter electrode 30, before subsequently moving into the electrolyte layer 20.

It should be noted that in FIG. 3, reference sign 10a indicates a photoelectrode base plate, reference sign 10b indicates a porous semiconductor fine particulate layer, reference sign 10c indicates a sensitizing dye layer, reference signs 10d and 30a indicate supports, reference signs 10e and 30c indicate conductive films, and reference sign 30b indicates a catalyst layer.

A presently disclosed photoelectrode for a dye-sensitized solar cell is obtained by using the transparent conductive film described above as the conductive film 10e of the photoelectrode 10. A presently disclosed dye-sensitized solar cell is obtained using a photoelectrode for a dye-sensitized solar cell such as described above.

Conventional commonly known configurations may be adopted without any specific limitations for aspects of configuration other than those described above. For example, a transparent resin substrate or a glass substrate can be used as the support 10d of the photoelectrode or the support 30a of the counter electrode, with a transparent resin substrate being particularly suitable.

Examples of transparent resins that can be used include synthetic resins such as cycloolefin polymer (COP), polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), and transparent polyimide (PI).

The semiconductor fine particles used for the porous semiconductor fine particulate layer 10b of the photoelectrode are for example particles of a metal oxide such as titanium oxide, zinc oxide, or tin oxide. The porous semiconductor fine particulate layer can be formed by a press method, a hydrothermal decomposition method, an electrophoretic deposition method, a binder-free coating method, or the like.

Examples of sensitizing dyes that can be adsorbed onto the surface of the porous semiconductor fine particulate layer to form the sensitizing dye layer 10c include organic dyes such as cyanine dyes, merocyanine dyes, oxonol dyes, xanthene dyes, squarylium dyes, polymethine dyes, coumarin dyes, riboflavin dyes, and perylene dyes; and metal complex dyes such as phthalocyanine complexes and porphyrin complexes of metals such as iron, copper, and ruthenium.

The sensitizing dye layer can for example be formed by a method in which the porous semiconductor fine particulate layer is immersed in a solution of the sensitizing dye or a method in which a solution of the sensitizing dye is applied onto the porous semiconductor fine particulate layer.

The electrolyte layer 20 typically contains a supporting electrolyte, a redox couple (i.e., a couple of chemical species that can be reversibly converted between in a redox reaction in the form of an oxidant and a reductant), a solvent, and so forth. The supporting electrolyte is for example a salt having a cation such as a lithium ion, an imidazolium ion, or a quaternary ammonium ion.

The redox couple enables reduction of the oxidized sensitizing dye and examples thereof include chlorine compound/chlorine, iodine compound/iodine, bromine compound/bromine, thallium(III) ions/thallium(I) ions, ruthenium(III) ions/ruthenium(II) ions, copper(II) ions/copper(I) ions, iron(III) ions/iron(II) ions, cobalt(III) ions/cobalt(II) ions, vanadium(III) ions/vanadium(II) ions, manganate ions/permanganate ions, ferricyanide/ferrocyanide, quinone/hydroquinone, and fumaric acid/succinic acid.

Examples of solvents that can be used include solvents used for forming electrolyte layers of solar cells such as acetonitrile, methoxyacetonitrile, methoxypropionitrile, N,N-dimethylformamide, ethylmethylimidazolium bis(trifluoromethylsufonyl)imide, and propylene carbonate.

The electrolyte layer can for example be formed by applying a solution (electrolysis solution) including the components of the electrolyte layer onto the photoelectrode or by preparing a cell including the photoelectrode and the counter electrode and then injecting the electrolysis solution into a gap between the electrodes.

The catalyst layer 30b of the counter electrode 30 acts as a catalyst for transferring electrons from the counter electrode to the electrolyte layer and is typically formed by a platinum thin-film. Instead of a platinum thin-film, the catalyst layer 30b may be formed by CNTs having the characteristics described above, another carbon material such as graphite or graphene, or a conductive polymer such as poly(3,4-ethylenedioxythiophene) (PEDOT). A thickness in a range of from 1 nm to 0.1 µm is normally suitable for the catalyst layer.

Furthermore, although the conductive film 30c of the counter electrode can be a conductive film made from a composite metal oxide such as indium tin oxide (ITO) or indium zinc oxide (IZO) (suitable thickness: 0.01 µm to 100 µm), in the same way as described above, the conductive film 30c may alternatively be formed using CNTs having the characteristics described above, another carbon material such as graphite or graphene, or a conductive polymer such as poly(3,4-ethylenedioxythiophene) (PEDOT). A thickness in a range of from 0.01 µm to 100 µm is normally suitable for the conductive film.

In a situation in which a catalyst layer and a conductive film that each contain CNTs having the characteristics described above are used as the catalyst layer 30b and the conductive film 30c of the counter electrode 30, corrosion and the like can be prevented and durability can be improved.

A catalyst layer and a conductive film such as described above can each be formed through application and drying of a CNT dispersion liquid in which the CNTs are dispersed. Furthermore, when forming such a catalyst layer or conductive film, the CNT dispersion liquid has good application properties, processability accuracy is significantly improved, and high-speed application and processed film manufacture by a roll-to-roll process are facilitated, which improves manufacturability and is extremely advantageous in terms of dye-sensitized solar cell mass production.

In particular, formation of the CNT-containing catalyst layer and conductive film as a single layer that combines functions of the conductive film and the catalyst layer further improves manufacturability and is therefore even more advantageous in terms of dye-sensitized solar cell mass production.

On the other hand, in a situation in which the CNT-containing catalyst layer and conductive film are provided separately, the functions of the conductive film and the catalyst layer can be separated. In such a situation, the following characteristics are suitable for CNTs contained in the conductive film and CNTs contained in the catalyst layer. Characteristics other than those shown below are the same as for the previously described CNTs.
- CNTs used for catalyst layer
   Average length: 0.1 µm to 1 cm
   Specific surface area: 600 m²/g to 1,600 m²/g
   Mass density: 0.002 g/cm³ to 0.1 g/cm³
- CNTs used for conductive film
   Average length: 0.1 µm to 1 cm
   Specific surface area: 400 m²/g to 1,200 m²/g
   Mass density: 0.002 g/cm³ to 0.1 g/cm³

Furthermore, in the situation described above, the total thickness of the CNT-containing catalyst layer and conductive film is preferably within a range of 100 µm of a total value of the minimum thicknesses for these layers described above.

The reason for this is that accuracy during pasting may be poor if the total thickness of the CNT-containing catalyst layer and conductive film is greater than 100 µm, whereas conductivity tends to deteriorate if the total thickness is less than the lower limit. A more preferable upper limit is 10 µm.

Furthermore, it is expected that catalytic activity of the CNT-containing catalyst layer (inclusive of a case in which the catalyst layer also functions as a conductive film) can be further improved if metal nanoparticles are supported by the CNT-containing catalyst layer.

Herein, examples of metal nanoparticles that can be used include nanoparticles of metals in groups 6 to 14 of the periodic table.

Examples of metals in groups 6 to 14 of the periodic table include Cr, Mn, Fe, Co, Ni, Cu, Zn, Ga, Ru, Rh, Pd, Ag, Cd, Sn, Sb, W, Re, Ir, Pt, Au, and Pb. Among these examples, Fe, Co, Ni, Ag, W, Ru, Pt, Au, and Pd are preferable for obtaining a highly versatile redox catalyst.

Any one of such metals may be used or any two or more of such metals may be used in combination.

From a viewpoint of improving catalytic effect, the metal nanoparticles preferably have an average particle diameter of from 0.5 nm to 15 nm, and preferably have a particle diameter standard deviation of no greater than 1.5 nm.

Although no specific limitations are placed on the amount of supported metal nanoparticles, the amount is preferably at least 1 part by mass per 100 parts by mass of the carbon nanotubes. Even better catalytic activity can be obtained as a result of the supported amount of metal nanoparticles being at least 1 part by mass. Although catalytic activity is thought to continue increasing as the supported amount of metal nanoparticles increases, when supporting ability of the CNTs and economic factors are taken into account, an upper limit for the supported amount of metal nanoparticles of 30,000 parts by mass per 100 parts by mass of the CNTs is normally preferable.

No specific limitations are placed on the method by which the metal nanoparticles are caused to be supported by the CNTs. For example, the metal nanoparticles can be caused to be supported by the CNTs through a commonly known method in which a metal precursor is reduced in the presence of the CNTs to produce the metal nanoparticles.

More specifically, a dispersion liquid containing water or an alcohol, the CNTs, and a dispersant is prepared and solvent is evaporated after addition of the metal precursor. Next, heating is performed under hydrogen gas flow to reduce the metal precursor, thereby efficiently obtaining a metal nanoparticle support of produced metal nanoparticles supported by the CNTs. Although no specific limitations are placed on the amount of the metal precursor that is added to the dispersion liquid, from a viewpoint of efficiently obtaining the metal nanoparticle support of the metal nanoparticles supported by the CNTs, the dispersion liquid preferably has a metal precursor content of from 1.0 x 10⁻¹⁰ mass% to 1.0 x 10⁻⁸ mass% after addition of the metal precursor.

### [Touch panel]

A presently disclosed touch panel is obtained using the presently disclosed transparent conductive film.

Herein, the touch panel may for example be a surface capacitance touch panel, a projected capacitance touch panel, or a resistive film touch panel.

The presently disclosed touch panel has excellent visibility and durability as a result of adoption of the presently disclosed transparent conductive film.

### EXAMPLES

### (Synthesis of carbon nanotubes)

An aligned CNT aggregate was obtained by the super growth method in accordance with the description in WO 2006/011655 A1.

The obtained aligned CNT aggregate had a BET specific surface area of 800 m²/g, a mass density of 0.03 g/cm³, and a micropore volume of 0.44 mL/g. Measurement of diameters of 100 random CNTs using a transmission electron microscope gave results of an average diameter (Av) of 3.3 nm, a diameter distribution (3σ) of 1.9 nm, and 3σ/Av of 0.58. The aligned CNT aggregate that was obtained was composed mainly of single-walled CNTs.

### (Preparation of carbon nanotube dispersion liquid (dispersion liquid 1))

A carbon nanotube dispersion liquid (dispersion liquid 1) having a concentration of 50 ppm was obtained by adding N-methylpyrrolidone into a 30-mL glass container, further adding and mixing 0.0025 g of CNTs synthesized as described above, and performing dispersion treatment for 60 minutes using an immersion ultrasonic disperser.

### (Preparation of Ag nanowire dispersion liquid (dispersion liquid 2))

A Ag nanowire dispersion liquid (dispersion liquid 2) was obtained by adding 10 g of water and 10 g of ethanol into a 30-mL glass container and further adding and mixing 0.1 g of Ag nanowires (produced by Sigma-Aldrich Co. LLC, diameter 100 nm).

### (Preparation of Ag nanowire-containing carbon nanotube dispersion liquid (dispersion liquid 3))

A Ag nanowire-containing carbon nanotube dispersion liquid (dispersion liquid 3) was obtained by measuring 15 mL each of the dispersion liquids 1 and 2 into a 30-mL glass container and performing stirring for 1 hour using a magnetic stirrer.

### Example 1

### (1) Preparation of transparent conductive film

A Ag nanowire-containing layer was formed by applying the dispersion liquid 2 onto a glass base plate by spray coating and leaving the resultant applied film at room temperature for 2 hours. The Ag nanowire-containing layer had a Ag nanowire content of 0.15 mg/cm². A CNT-containing layer was formed by applying the dispersion liquid 1 onto the Ag nanowire-containing layer by spray coating with an application thickness of 50 nm and leaving the resultant applied film at room temperature for 3 hours. The CNT-containing layer had a CNT content of 0.006 mg/cm².

Next, an oxide layer of tin was formed by spin coating one surface of the CNT-containing layer with a 5% tin tetraisopropoxide solution for 30 seconds at 3,000 rpm, and heating the resultant product on a hot plate set to a temperature of 150°C to obtain a transparent conductive film.

### (2) Preparation of photoelectrode

A porous titanium oxide electrode was prepared by applying low-temperature film formation titanium oxide paste (produced by Peccell Technologies, Inc.) onto the transparent conductive film prepared as described above, and after drying the applied film, heating the dried product to 150°C for 10 minutes using a hot plate. The titanium oxide electrode was immersed in a 0.3 mM N719 dye solution. In order to ensure sufficient dye adsorption, a target of at least 2 mL of the dye solution per one electrode was set for the immersion.

Adsorption of the dye was carried out while maintaining the dye solution at 40°C. After 2 hours, a titanium oxide film for which dye adsorption was complete was removed from a dish containing the dye solution, was washed with acetonitrile solution, and was dried.

### (3) Preparation of dye solution

A 20-mL volumetric flask was charged with 7.2 mg of a ruthenium complex dye (N719 produced by Solaronix). Stirring was performed after mixing 10 mL of tert-butanol into the volumetric flask. Thereafter, 8 mL of acetonitrile was added to the volumetric flask, and the volumetric flask was capped and stirred for 60 minutes through vibration using an ultrasonic cleaner. The solution was maintained at room temperature while adding acetonitrile to reach a total volume of 20 mL.

### (4) Preparation of dye-sensitized solar cell

A dye-sensitized solar cell was prepared as follows. First. a circular shape of 9 mm in diameter was cut out from an inner part of a hot-melt film of 25 µm in thickness (produced by Solaronix) and the cut out film was set on a platinum electrode. Next, an electrolysis solution was dripped onto the film, the photoelectrode prepared in (2) was overlapped from above, and an electrical clip was used to sandwich both sides therebetween.

### Example 2

An oxide layer of niobium was formed on a carbon nanotube-containing layer prepared in the same way as in Example 1 by spin coating the carbon nanotube-containing layer with a 5% niobium pentaethoxide solution for 30 seconds at 3,000 rpm, and heating the resultant product on a hot plate set to 150°C.

With the exception of the above, a transparent conductive film was prepared with the same configuration as in Example 1. Furthermore, the obtained transparent conductive film was used to prepare a dye-sensitized solar cell with the same configuration as in Example 1.

### Example 3

A Ag nanowire-containing CNT layer was formed by applying the dispersion liquid 3 onto a glass base plate by spray coating with an application thickness of 50 nm, and leaving the resultant applied film at room temperature for 3 hours.

Next, an oxide layer of tin was formed by spin coating Ag nanowire-containing CNT layer with a 5% tin tetraisopropoxide solution for 30 seconds at 3,000 rpm, and heating the resultant product on a hot plate set to 150°C.

With the exception of the above, a transparent conductive film was prepared with the same configuration as in Example 1. Furthermore, the obtained transparent conductive film was used to prepare a dye-sensitized solar cell with the same configuration as in Example 1.

### Example 4

A CNT-containing layer was formed by applying the dispersion liquid 1 onto a glass base plate by spray coating with an application thickness of 50 nm, and leaving the resultant applied film at room temperature for 3 hours. The CNT-containing layer had a CNT content of 0.006 mg/cm².

Next, an oxide layer of tin was formed by spin coating the CNT-containing layer with a 5% tin tetraisopropoxide solution for 30 seconds at 3,000 rpm, and heating the resultant product on a hot plate set to 150°C.

With the exception of the above, a transparent conductive film was prepared with the same configuration as in Example 1. Furthermore, the obtained transparent conductive film was used to prepare a dye-sensitized solar cell with the same configuration as in Example 1.

### Comparative Example 1

An oxide layer of titanium was formed on a carbon nanotube-containing layer prepared in the same way as in Example 1 by spin coating the carbon nanotube-containing layer with a 5% titanium tetraisopropoxide solution for 30 seconds at 3,000 rpm, and heating the resultant product on a hot plate set to 150°C.

With the exception of the above, a transparent conductive film was prepared with the same configuration as in Example 1. Furthermore, the obtained transparent conductive film was used to prepare a dye-sensitized solar cell with the same configuration as in Example 1.

The sheet resistance of each of the transparent conductive films obtained as described above was measured in accordance with JIS K 7194 by a four-terminal four-pin method using a resistivity meter (Loresta^{®} GP (Loresta is a registered trademark in Japan, other countries, or both) produced by Mitsubishi Chemical Corporation).

Furthermore, close adherence was evaluated by conducting a tape peeling test and visually judging the ratio of peeling onto the tape. The judgment was based on the following standard.
Good: No peeling
Poor: Peeling

The results are shown in Table 1.

**[Table 1]**

| | Example 1 | Example 2 | Example 3 | Comparative Example 1 |
|---|---|---|---|---|
| Sheet resistance value (Ω/sq) | 50 | 55 | 45 | 65 |
| Evaluation of close adherence | Good | Good | Good | Poor |

It can be seen from Table 1 that the sheet resistance value was considerably lower for the transparent conductive films of Examples 1-3 in which an oxide layer of tin or niobium had been formed on the CNT layer, compared to the transparent conductive film of Comparative Example 1 in which an oxide layer of titanium had been formed on the CNT layer. Moreover, close adherence was improved for the films in Examples 1-3. Note that transparency was roughly the same.

Cell characteristics of each of the dye-sensitized solar cells obtained as described above were evaluated as follows.

Specifically, a solar simulator (PEC-L11 produced by Peccell Technologies, Inc.) in which an AM1.5G filter was attached to a 150 W xenon lamp light source was used as a light source. The illuminance was adjusted to values of 10,000 1x and 100,000 1x. Each of the dye-sensitized solar cells obtained as described above was connected to a sourcemeter (Series 2400 SourceMeter produced by Keithley Instruments).

A current/voltage characteristic was measured under illumination of 10,000 1x and 100,000 1x by measuring output current while changing bias voltage from 0 V to 0.8 V in 0.01 V units. The output current was measured for each voltage step by, after the voltage had been changed, integrating values from 0.05 seconds after the voltage change to 0.15 seconds after the voltage change. Measurement was also performed while stepping the bias voltage in the reverse direction from 0.8 V to 0 V, and an average value of measurements for the forward direction and the reverse direction was taken to be a photoelectric current.

These measurements were used to calculate the open-circuit voltage (V), the fill factor, and the energy conversion efficiency (%). The measurement results are shown in Table 2.

**[Table 2]**

| | | Example 1 | Example 2 | Example 3 | Comparative Example 1 |
|---|---|---|---|---|---|
| Illuminance: 100,000 lx | Short-circuit current density (mA/cm²) | 1.98 | 1.97 | 2.18 | 1.70 |
| | Open-circuit voltage (V) | 0.74 | 0.73 | 0.73 | 0.61 |
| | Fill factor | 0.41 | 0.39 | 0.42 | 0.35 |
| | Energy conversion efficiency (%) | 0.60 | 0.56 | 0.67 | 0.36 |
| Illuminance: 10,000 lx | Short-circuit current density (mA/cm²) | 0.58 | 0.51 | 0.62 | 0.45 |
| | Open-circuit voltage (V) | 0.71 | 0.75 | 0.70 | 0.63 |
| | Fill factor | 0.71 | 0.61 | 0.71 | 0.55 |
| | Energy conversion efficiency (%) | 2.91 | 2.33 | 3.1 | 1.56 |

It can be seen from Table 2 that energy conversion efficiency was significantly improved, generation of reverse current was effectively prevented, and cell characteristics were greatly improved for the dye-sensitized solar cells of Examples 1-3 compared to the dye-sensitized solar cell of Comparative Example 1, both when the illuminance was 10,000 lx and when the illuminance was 100,000 lx.

Note that in Example 4 in which the transparent conductive film and the dye-sensitized solar cell were obtained without using Ag nanowires, although performance was slightly lower than in Examples 1-3, the same trends in improved performance were observed as in Examples 1-3.

### REFERENCE SIGNS LIST

- 1: carbon nanotube-containing layer (1)
- 2: oxide layer (2) of tin or niobium
- 3: metal nanostructure-containing layer (3)
- 10: photoelectrode
- 10a: photoelectrode base plate
- 10b: porous semiconductor fine particulate layer
- 10c: sensitizing dye layer
- 10d: support
- 10e: conductive film
- 20: electrolyte layer
- 30: counter electrode
- 30a: support
- 30b: catalyst layer
- 30c: conductive film
- 40: external circuit

## Claims

1. A transparent conductive film comprising:
a carbon nanotube-containing layer (1) containing carbon nanotubes having an average diameter Av and a diameter standard deviation σ that satisfy a relationship 0.60 > 3σ/Av > 0.20; and
an oxide layer (2) of tin or niobium on one surface of the carbon nanotube-containing layer (1).

2. The transparent conductive film of claim 1, wherein
the carbon nanotube-containing layer (1) further contains a metal nanostructure.

3. The transparent conductive film of claim 1, further comprising
a metal nanostructure-containing layer (3) on another surface of the carbon nanotube-containing layer (1).

4. A photoelectrode for a dye-sensitized solar cell, the photoelectrode comprising the transparent conductive film of any one of claims 1-3.

5. A touch panel comprising the transparent conductive film of any one of claims 1-3.

6. A dye-sensitized solar cell comprising the photoelectrode of claim 4.
